# EUROPEAN PATENT APPLICATION

(11) **EP 4 723 117 A1**
(43) Date of publication of application: **08.04.2026**
(21) Application number: 24218095.8
(22) Date of filing: 06.12.2024
(51) Int. Cl.: G11C 11/16, G11C 11/18, H01F 10/32, H10N 50/10

(54) **MAGNETIC DEVICE CAPABLE OF FIELD-FREE SPIN-ORBIT TORQUE AND METHOD FOR MANUFACTURING SAME**

(30) Priority: 07.10.2024 KR 20240136137
(71) Applicant: Korea Advanced Institute of Science and Technology, Daejeon 34141 (KR)
(72) Inventor: PARK, Byong Guk, 34141 Daejeon (KR); KIM, Nam Hee, 34141 Daejeon (KR); HAN, Dong Hyeon, 34141 Daejeon (KR)
(74) Representative: Zimmermann, Tankred Klaus

(57) **Abstract**

An embodiment of the disclosure provides a magnetic device capable of field-free spin-orbit torque, including: a fixed ferromagnetic layer; a free ferromagnetic layer; and an insulating layer positioned between the fixed ferromagnetic layer and the free ferromagnetic layer, wherein the free ferromagnetic layer includes: an in-plane magnetic anisotropy ferrimagnetic layer; a perpendicular magnetic anisotropy free ferromagnetic layer; and a non-magnetic layer positioned between the in-plane magnetic anisotropy ferrimagnetic layer and the perpendicular magnetic anisotropy free ferromagnetic layer.

## Description

### BACKGROUND

The disclosure relates to a magnetic device capable of field-free spin-orbit torque and a method for manufacturing the same, and more specifically, to a magnetic device capable of field-free spin-orbit torque and a method for manufacturing the same, in which energy efficiency is improved by introducing a ferrimagnetic material having a composition corresponding to a range near a magnetization compensation point.

Magnetic memory is a nonvolatile memory that can maintain information without external power, and has a multilayer thin film structure including a magnetic layer.

Currently mass-produced magnetic memories operate on spin transfer torque technology, and this technology injects a vertical current into a magnetic tunnel junction of a ferromagnetic/insulating layer/ferromagnetic structure to achieve magnetization reversal, but has the disadvantages of the relatively slow operation speed, high device error rate, and low stability.

The spin-orbit torque technology that is being studied recently is a switching technology that uses torque generated by spin current generated by spin orbital interaction, and the spin-orbit torque technology has the advantages of the fast operation speed, high device stability because of the high write current not flowing to the insulating layer, and low error rate because of different read/write currents.

However, an external magnetic field is required for magnetization reversal and a relatively large switching current is required, so the development of technology to overcome this is necessary.

The disclosure provides a measure for improving the switching energy efficiency of a spin-orbit torque magnetic memory by utilizing spin current generated in a ferrimagnetic/non-magnetic structure using a quasi-magnetic (ferrimagnetic) material as a spin current generating material in a spin-orbit torque magnetic memory device capable of switching without an external magnetic field.

### [Related art]

### [Patent document]

Republic of Korea Patent No. 10-1940669

### SUMMARY

An aspect of the disclosure is to provide a magnetic device capable of field-free spin-orbit torque and a method for manufacturing the same, in which energy efficiency is improved by introducing a ferrimagnetic material having a composition corresponding to a range near a magnetization compensation point.

The aspect of the disclosure is not limited to that mentioned above, and other aspects not mentioned will be clearly understood by those skilled in the art from the description below.

An embodiment of the disclosure provides a magnetic device capable of field-free spin-orbit torque.

A magnetic device capable of field-free spin-orbit torque according to an embodiment of the disclosure may include: a fixed ferromagnetic layer; a free ferromagnetic layer; and an insulating layer positioned between the fixed ferromagnetic layer and the free ferromagnetic layer, wherein the free ferromagnetic layer includes: an in-plane magnetic anisotropy ferrimagnetic layer; a perpendicular magnetic anisotropy free ferromagnetic layer; and a non-magnetic layer positioned between the in-plane magnetic anisotropy ferrimagnetic layer and the perpendicular magnetic anisotropy free ferromagnetic layer.

In addition, according to an embodiment of the disclosure, the in-plane magnetic anisotropy ferrimagnetic layer may have an in-plane saturation magnetization (Mₛ) value of 500 emu/cc or less.

In addition, according to an embodiment of the disclosure, the in-plane magnetic anisotropy ferrimagnetic layer may have a thickness range of 2 to 20 nm.

In addition, according to an embodiment of the disclosure, a material constituting the in-plane magnetic anisotropy ferrimagnetic layer may be represented by Chemical Formula 1:

[Chemical Formula 1] CoₓGd_{y}

In Chemical Formula 1, x and y represent the composition ratio of Co and Gd, respectively, and the sum of the x and y values is 100.

In addition, according to an embodiment of the disclosure, the x may be a number greater than or equal to 60 and less than or equal to 90.

In addition, according to an embodiment of the disclosure, the non-magnetic layer may include at least one selected from the group consisting of alloys including Pt, Ta, W, Ti, and combinations thereof.

In addition, according to an embodiment of the disclosure, a spin current occurring in the in-plane magnetic anisotropy ferrimagnetic layer and the non-magnetic layer may apply a torque to the perpendicular magnetic anisotropy free ferromagnetic layer, thereby switching the magnetization direction of the perpendicular magnetic anisotropy free ferromagnetic layer.

Another embodiment of the disclosure provides a method for manufacturing a magnetic device capable of field-free spin-orbit torque.

A method for manufacturing a magnetic device capable of field-free spin-orbit torque according to an embodiment of the disclosure may include: forming a fixed ferromagnetic layer; forming an insulating layer on the fixed ferromagnetic layer; and forming a free ferromagnetic layer on the insulating layer, wherein the forming of the free ferromagnetic layer includes: forming a perpendicular magnetic anisotropy free ferromagnetic layer; forming a non-magnetic layer on the perpendicular magnetic anisotropy free ferromagnetic layer; and forming an in-plane magnetic anisotropy ferrimagnetic layer on the non-magnetic layer.

In addition, according to an embodiment of the disclosure, in the forming of the in-plane magnetic anisotropy ferrimagnetic layer, the in-plane magnetic anisotropy ferrimagnetic layer may have an in-plane saturation magnetization (Mₛ) value of 500 emu/cc or less.

In addition, according to an embodiment of the disclosure, in the forming of the in-plane magnetic anisotropy ferrimagnetic layer, the in-plane magnetic anisotropy ferrimagnetic layer has a thickness range of 2 to 20 nm.

In addition, according to an embodiment of the disclosure, in the forming of the in-plane magnetic anisotropy ferrimagnetic layer, the in-plane magnetic anisotropy ferrimagnetic layer may be composed of a material represented by Chemical Formula 1:

[Chemical Formula 1] CoₓGd_{y}

In Chemical Formula 1, x and y represent the composition ratio of Co and Gd, respectively, and the sum of the x and y values is 100.

In addition, according to an embodiment of the disclosure, the x may be a number greater than or equal to 60 and less than or equal to 90.

In addition, according to an embodiment of the disclosure, the forming of the free ferromagnetic layer on the insulating layer may be performed by at least one scheme selected from the group consisting of sputtering, molecular beam epitaxy (MBE), atomic layer deposition (ALD), physical vapor deposition (PVD), and chemical vapor deposition (CVD).

According to an embodiment of the disclosure, it is possible to provide a magnetic device capable of field-free spin-orbit torque and a method for manufacturing the same, in which energy efficiency is improved by introducing a ferrimagnetic material having a composition corresponding to a range near a magnetization compensation point.

According to an embodiment of the disclosure, a field-free switching current of a spin-orbit torque element may be lowered to increase the energy efficiency of a spin-orbit torque magnetic memory.

According to an embodiment of the disclosure, the composition of a material constituting a ferrimagnetic layer may be controlled to maximize the switching energy efficiency near a magnetization compensation point.

The effects of the disclosure are not limited to the effects described above, and should be understood to include all effects that are inferable from the configuration of the disclosure described in the detailed description or claims of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view showing the overall structure of a magnetic device according to an embodiment of the disclosure;
FIG. 2 is a graph showing a hysteresis curve according to the composition of an in-plane magnetic anisotropy ferrimagnetic layer (CoGd) of a magnetic device according to an embodiment of the disclosure;
FIG. 3 is a graph showing an in-plane magnetic moment and coercivity according to the composition of an in-plane magnetic anisotropy ferrimagnetic layer (CoGd) of a magnetic device according to an embodiment of the disclosure;
FIG. 4 is a schematic view showing the structure of a magnetic device and a spin-orbit torque switching characteristic measurement according to an embodiment of the disclosure;
FIG. 5 is a graph showing the spin-orbit torque switching behavior of a magnetic device (Co₁₀₀Gd₀) according to a comparative example of the disclosure;
FIG. 6 is a graph showing the spin-orbit torque switching behavior of a magnetic device (Co₆₀Gd₄₀) according to an embodiment of the disclosure;
FIG. 7 is a graph showing the switching current density according to the composition of an in-plane magnetic anisotropy ferrimagnetic layer (CoGd) of a magnetic device according to an embodiment of the disclosure;
FIG. 8 is a graph showing the field-free spin-orbit torque switching behavior of a magnetic device (Co₁₀₀Gd₀) according to a comparative example of the disclosure;
FIG. 9 is a graph showing the field-free spin-orbit torque switching behavior of a magnetic device (Co₇₀Gd₃₀) according to an embodiment of the disclosure;
FIG. 10 is a graph showing the field-free switching current density according to the composition of an in-plane magnetic anisotropy ferrimagnetic layer (CoGd) of a magnetic device according to an embodiment of the disclosure;
FIG. 11 is a graph showing the abnormal Hall effect shift when an external magnetic field in the plane direction of a magnetic device (Co₇₀Gd₃₀) is present according to an embodiment of the disclosure;
FIG. 12 is a graph showing the abnormal Hall effect shift when an external magnetic field in the plane direction of a magnetic device (Co₇₀Gd₃₀) is absent according to an embodiment of the disclosure;
FIG. 13 is a graph showing the spin-orbit torque efficiency of a magnetic device (Co₇₀Gd₃₀) according to an embodiment of the disclosure;
FIG. 14 is a graph showing the y-spin efficiency according to the composition of an in-plane magnetic anisotropy ferrimagnetic layer (CoGd) of a magnetic device according to an embodiment of the disclosure; and
FIG. 15 is a graph showing the z-spin efficiency according to the composition of an in-plane magnetic anisotropy ferrimagnetic layer (CoGd) of a magnetic device according to an embodiment of the disclosure.

### DETAILED DESCRIPTION

Hereinafter, the disclosure will be described with reference to the accompanying drawings. However, the disclosure may be implemented in various different forms, and therefore is not limited to the embodiments described herein.

In addition, in order to clearly describe the disclosure in the drawings, parts that are not related to the description are omitted, and similar parts are given similar drawing reference numerals throughout the specification.

In the entire specification, when a part is said to be "connected (linked, contacted, coupled)" to another part, this includes not only the case where it is "directly connected" but also the case where it is "indirectly connected" with another member in between.

In addition, when a part is said to "include" a certain component, this does not mean that other components are excluded unless otherwise specifically stated, but that other components may be additionally provided. In addition, in this specification, when a part such as a layer, film, region, or plate is formed on another part, the direction in which it is formed is not limited to the upper direction, and includes being formed in the side or lower direction. On the other hand, when a part such as a layer, film, region, or plate is said to be "under" another part, this includes not only the case where it is "directly under" another part, but also the case where there is another part in between.

In this specification, the terms "upper surface" and "lower surface" are used as relative concepts in order to easily explain the technical idea of the disclosure. Therefore, the terms "upper surface" and "lower surface" do not refer to a specific direction, position, or component, and are interchangeable with each other.

For example, the "upper surface" may be interpreted as the "lower surface," and the "lower surface" may be interpreted as the "upper surface." Therefore, the "upper surface" may be expressed as "first" and the "lower surface" may be expressed as "second", or the "lower surface" may be expressed as "first" and the "upper surface" may be expressed as "second". However, within one embodiment, the terms "upper surface" and "lower surface" are not used interchangeably.

Unless otherwise defined, all terms used herein, including technical or scientific terms, have the same meaning as generally understood by a person of ordinary skill in the art to which the disclosure belongs. Terms defined in commonly used dictionaries should be interpreted as having a meaning consistent with the meaning they have in the context of the relevant technology, and shall not be interpreted in an ideal or overly formal sense unless explicitly defined in this application.

In addition, when a part is said to "include" a certain component, this does not exclude other components unless specifically stated to the contrary, but rather means that other components may be additionally provided.

The terms used in this specification are used only to describe specific embodiments and are not intended to limit the disclosure. The singular expression includes the plural expression unless the context clearly indicates otherwise. In this specification, the terms "include" or "have" are intended to specify the presence of a feature, number, step, operation, component, part, or combination thereof described in the specification, but should be understood as not excluding in advance the possibility of the presence or addition of one or more other features, numbers, steps, operations, components, parts, or combinations thereof.

Hereinafter, embodiments of the disclosure will be described in detail with reference to the accompanying drawings.

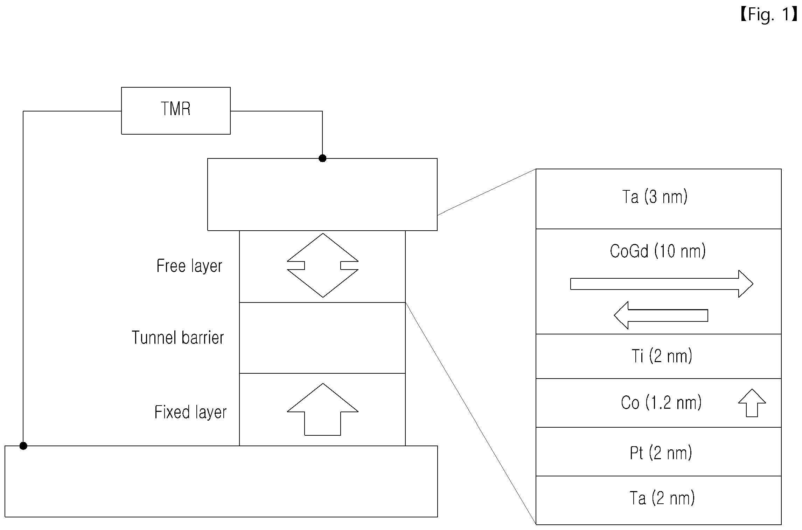

FIG. 1 is a schematic view showing the overall structure of a magnetic device according to an embodiment of the disclosure.

Referring to FIG. 1, a magnetic device capable of field-free spin-orbit torque according to an embodiment of the disclosure will be described.

As an example of the embodiment, a magnetic device capable of field-free spin-orbit torque may include: a fixed ferromagnetic layer; a free ferromagnetic layer; and an insulating layer positioned between the fixed ferromagnetic layer and the free ferromagnetic layer, wherein the free ferromagnetic layer includes: an in-plane magnetic anisotropy ferrimagnetic layer; a perpendicular magnetic anisotropy free ferromagnetic layer; and a non-magnetic layer positioned between the in-plane magnetic anisotropy ferrimagnetic layer and the perpendicular magnetic anisotropy free ferromagnetic layer.

Referring to the schematic view of FIG. 1, it is possible to confirm that an insulating layer (Tunnel barrier) is positioned between a fixed ferromagnetic layer (Fixed layer) and a free ferromagnetic layer (Free layer), and the free ferromagnetic layer (Free layer) has a structure in which a non-magnetic layer (Ti) is positioned between an in-plane magnetic anisotropy ferrimagnetic layer (CoGd) and a perpendicular magnetic anisotropy free ferromagnetic layer (Co).

At this time, the in-plane magnetic anisotropy (IMA) refers to a property in which the magnetization direction of a magnetic material is aligned in a preferred direction within the plane of a film or thin film (i.e., horizontal direction).

Due to the structural characteristics or crystal structure of the magnetic layer, magnetization prefers a specific direction within the plane, and as a result, magnetization may be stably maintained within the plane even in the absence of an external magnetic field.

The perpendicular magnetic anisotropy (PMA) refers to the property that the magnetization direction of a magnetic material is aligned perpendicular to the plane of a film or thin film (i.e., vertical direction).

The above characteristic is frequently observed in thin magnetic thin films, and high-density magnetic information storage is possible because the magnetization is aligned perpendicular to the plane.

The disclosure provides a measure for increasing the switching energy effi ciency of a spin-orbit torque magnetic memory by utilizing spin current ge nerated in a ferrimagnetic/non-magnetic structure using a ferrimagnetic mat erial as a spin current generating material, in configuring a free layer of a spin-orbit torque magnetic memory device that may be switched without an external magnetic field.

At this time, the ferrimagnetic material is a material that has magnetism similar to a ferromagnetic material, but has two or more sub-lattices aligned in opposite directions, and the magnetization magnitude between these sub-lattices is different, so that net magnetization occurs.

The ferrimagnetic material has the characteristic that the magnetic moments of the sub lattices having two different magnetization directions are aligned in opposite directions, but the overall magnetization is not offset and maintains a constant magnetism.

On the other hand, ferromagnetic materials such as iron (Fe), cobalt (Co), and nickel (Ni) have the characteristic that the magnetic moments of the atoms are aligned in the same direction even in the absence of an external magnetic field due to the strong interaction of magnetic atoms, and therefore, there is a difference from the ferrimagnetic material.

In the embodiment of the disclosure, the composition of the in-plane magnetic anisotropy ferrimagnetic layer includes a material in which the magnetization directions of the two sub lattices having different sizes are aligned in an antiparallel manner, and by controlling the composition or temperature of the ferrimagnetic material, the coercivity and saturation magnetization value may be controlled, thereby solving the problems of the above-mentioned conventional technology and maximizing the switching energy efficiency of the spin-orbit torque magnetic memory.

Meanwhile, non-magnetic materials such as copper (Cu), gold (Au), and silver (Ag) are materials of which magnetic moments are randomly aligned and which are thus not magnetized by an external magnetic field.

These materials have no residual magnetization when the external magnetic field is removed, and have very weak or no magnetic properties.

As described above, the free ferromagnetic layer includes a triple layer structure of an in-plane magnetic anisotropy ferrimagnetic layer/non-magnetic layer/perpendicular magnetic anisotropy free ferromagnetic layer.

At this time, when a current is applied in the in-plane direction, a spin current is generated in the in-plane magnetic anisotropy ferrimagnetic/non-magnetic layer structure, this spin current generates a spin torque of an in-plane component and a component perpendicular to the plane, and this spin torque enables the magnetization of the upper perpendicular magnetic anisotropy ferromagnetism to be switched without an external magnetic field.

In the case of a magnetic device according to the embodiment, the switching efficiency may vary depending on the composition of the ferrimagnetic layer.

Basically, the switching efficiency can be increased by making the ferrimagnetic material have a composition corresponding to a range near the magnetization compensation point.

As mentioned above, a ferrimagnetic material has two or more sub-lattices, and each of these sub-lattices has magnetization aligned in the opposite direction.

The magnetization compensation point refers to a point where the magnetization magnitudes of the two sub-lattices become equal to each other, so that the total magnetization becomes 0.

Therefore, in the case of a ferromagnetic material that has a single magnetization direction because all magnetic atoms in the material try to have magnetization in the same direction, there are no two sub-lattices with magnetization aligned in the opposite direction; therefore, the situation where the magnetization is canceled does not occur, so the magnetization compensation point does not exist.

The magnetization compensation point has the smallest saturation magnetization value (Mₛ) and the largest coercivity (B_{c}).

The saturation magnetization value (Mₛ) refers to the maximum magnetization value at which a magnetic material can no longer be magnetized.

That is, this is a magnetization state when an external magnetic field (or current) is applied sufficiently strongly so that all magnetic moments in a magnetic material are aligned in the same direction.

The coercive force (B_{c}) means the strength of an external magnetic field required to reverse the magnetization of a magnetic material.

As an example of the embodiment, the in-plane magnetic anisotropy ferrimagnetic layer may have an in-plane saturation magnetization (Mₛ) value of 500 emu/cc or less.

When the in-plane saturation magnetization (Mₛ) value is 50 emu/cc or less, the composition of the ferrimagnetic material is in a range near the magnetization compensation point, and through experimental examples below, it is possible to confirm that the switching energy efficiency is the highest in the above range.

More preferably, the in-plane magnetic anisotropy ferrimagnetic layer may have an in-plane saturation magnetization (Mₛ) value of 330 emu/cc or less.

Most preferably, the in-plane magnetic anisotropy ferrimagnetic layer may have an in-plane saturation magnetization (Mₛ) value of 100 emu/cc or less.

As an example of the embodiment, the in-plane magnetic anisotropy ferrimagnetic layer may have a thickness range of 2 to 20 nm.

If the thickness of the in-plane magnetic anisotropy ferrimagnetic layer is less than 2 nm, there is a problem that the ferrimagnetic properties are lost or it is difficult to control the desired composition, and on the contrary, if the thickness of the in-plane magnetic anisotropy ferrimagnetic layer exceeds 20 nm, a high current application is required to obtain a switching current density, and there is a problem that the switching efficiency increase effect is reduced.

As an example of the embodiment, a material constituting the in-plane magnetic anisotropy ferrimagnetic layer may be represented by Chemical Formula 1.

[Chemical Formula 1] CoₓGd_{y}

In Chemical Formula 1, x and y represent the composition ratio of Co and Gd, respectively, and the sum of the x and y values is 100.

At this time, in Chemical Formula 1, it is preferable that the x is a number having a range of 60 or more and 90 or less, more preferably, the x may be a number having a range of 60 or more and 85 or less, and most preferably, the x may be a number having a range of 75 or more and 80 or less.

Hereinafter, the switching and energy efficiency according to the composition range of the Co may be confirmed through experimental examples.

In the embodiment, although Ti is disclosed as the non-magnetic layer in FIG. 1, etc., it is not limited thereto, and the non-magnetic layer may include at least one selected from the group consisting of Pt, Ta, W, Ti, and an alloy composed of a combination thereof.

As an example of the embodiment, an interfacial spin current of the in-plane magnetic anisotropy ferrimagnetic layer and the non-magnetic layer may apply a torque to the perpendicular magnetic anisotropy free ferromagnetic layer, thereby switching the magnetization direction of the perpendicular magnetic anisotropy free ferromagnetic layer.

Hereinafter, a method for manufacturing a magnetic device capable of field-free spin-orbit torque according to another embodiment of the disclosure will be described.

The method for manufacturing a magnetic device capable of field-free spin-orbit torque corresponds to a different category of invention that shares the same technical idea as the magnetic device capable of field-free spin-orbit torque described above, and therefore, it is stated that the above-described content for the magnetic device capable of field-free spin-orbit torque may be applied as is.

As an example of the embodiment, the method for manufacturing a magnetic device capable of field-free spin-orbit torque may include: forming a fixed ferromagnetic layer; forming an insulating layer on the fixed ferromagnetic layer; and forming a free ferromagnetic layer on the insulating layer, wherein the forming of the free ferromagnetic layer includes: forming a perpendicular magnetic anisotropy free ferromagnetic layer; forming a non-magnetic layer on the perpendicular magnetic anisotropy free ferromagnetic layer; and forming an in-plane magnetic anisotropy ferrimagnetic layer on the non-magnetic layer.

As an example of the embodiment, in the forming of the in-plane magnetic anisotropy ferrimagnetic layer, the in-plane magnetic anisotropy ferrimagnetic layer may have an in-plane saturation magnetization (Mₛ) value of 500 emu/cc or less.

When the in-plane saturation magnetization (Mₛ) value is 50 emu/cc or less, the composition of the ferrimagnetic material is in a range near the magnetization compensation point, and through experimental examples below, it is possible to confirm that the switching energy efficiency is the highest in the above range.

More preferably, in the forming of the in-plane magnetic anisotropy ferrimagnetic layer, the in-plane magnetic anisotropy ferrimagnetic layer may have an in-plane saturation magnetization (Mₛ) value of 330 emu/cc or less.

Most preferably, in the forming of the in-plane magnetic anisotropy ferrimagnetic layer, the in-plane magnetic anisotropy ferrimagnetic layer may have an in-plane saturation magnetization (Mₛ) value of 100 emu/cc or less.

As an example of the embodiment, in the forming of the in-plane magnetic anisotropy ferrimagnetic layer, the in-plane magnetic anisotropy ferrimagnetic layer may have a thickness range of 2 to 20 nm.

If the thickness of the in-plane magnetic anisotropy ferrimagnetic layer is less than 2 nm, there is a problem that the ferrimagnetic properties are lost or it is difficult to control the desired composition, and on the contrary, if the thickness of the in-plane magnetic anisotropy ferrimagnetic layer exceeds 20 nm, a high current application is required to obtain a switching current density, and there is a problem that the switching efficiency increase effect is reduced.

As an example of the embodiment, in the forming of the in-plane magnetic anisotropy ferrimagnetic layer, the in-plane magnetic anisotropy ferrimagnetic layer may be composed of a material represented by Chemical Formula 1.

[Chemical Formula 1] CoₓGd_{y}

In Chemical Formula 1, x and y represent the composition ratio of Co and Gd, respectively, and the sum of the x and y values is 100.

At this time, in Chemical Formula 1, it is preferable that the x is a number having a range of 60 or more and 90 or less, more preferably, the x may be a number having a range of 60 or more and 85 or less, and most preferably, the x may be a number having a range of 75 or more and 80 or less.

Hereinafter, the switching and energy efficiency according to the composition range of the Co may be confirmed through experimental examples.

As an example of the embodiment, the forming of the free ferromagnetic layer on the insulating layer may be performed by at least one scheme selected from the group consisting of sputtering, molecular beam epitaxy (MBE), atomic layer deposition (ALD), physical vapor deposition (PVD), and chemical vapor deposition (CVD).

### Comparative manufacturing example 1. Formation of free ferromagnetic layer using ferromagnetic layer (Co₁₀₀)

A ferrimagnetic-based ferromagnetic electrode multilayer film composed of Ta(2nm) / Pt(2nm) / Co(1.2nm) / Ti(2nm) / Co₁₀₀(10nm) / Ta(3nm) is sequentially deposited using a sputtering scheme.

### Manufacturing example 1. Free ferromagnetic layer based on ferrimagnetic according to one embodiment of the disclosure (Co₉₀Gd₁₀)

In the magnetic device having the structure of FIG. 1, a free ferromagnetic layer is manufactured through the following process.

A ferrimagnetic-based ferromagnetic electrode multilayer film composed of Ta(2nm) / Pt(2nm) / Co(1.2nm) / Ti(2nm) / Co₉₀Gd₁₀(10nm) / Ta(3nm) is sequentially deposited using a sputtering scheme.

In the free ferromagnetic layer, Co may be utilized as a free magnetic layer of a magnetic tunnel junction, and the magnetization direction of Co may be switched by the spin-orbit torque generated from Ti/CoGd.

### Manufacturing example 2. Free ferromagnetic layer based on ferrimagnetic according to one embodiment of the disclosure (Co₈₅Gd₁₅)

In the magnetic device having the structure of FIG. 1, a free ferromagnetic layer is manufactured through the following process.

A ferrimagnetic-based ferromagnetic electrode multilayer film composed of Ta(2nm) / Pt(2nm) / Co(1.2nm) / Ti(2nm) / Co₈₅Gd₁₅(10nm) / Ta(3nm) is sequentially deposited using a sputtering scheme.

### Manufacturing example 3. Free ferromagnetic layer based on ferrimagnetic according to one embodiment of the disclosure (Co₈₀Gd₂₀)

In the magnetic device having the structure of FIG. 1, a free ferromagnetic layer is manufactured through the following process.

A ferrimagnetic-based ferromagnetic electrode multilayer film composed of Ta(2nm) / Pt(2nm) / Co(1.2nm) / Ti(2nm) / Co₈₀Gd₂₀(10nm) / Ta(3nm) is sequentially deposited using a sputtering scheme.

### Manufacturing example 4. Free ferromagnetic layer based on ferrimagnetic according to one embodiment of the disclosure (Co₇₅Gd₂₅)

In the magnetic device having the structure of FIG. 1, a free ferromagnetic layer is manufactured through the following process.

A ferrimagnetic-based ferromagnetic electrode multilayer film composed of Ta(2nm) / Pt(2nm) / Co(1.2nm) / Ti(2nm) / Co₇₅Gd₂₅(10nm) / Ta(3nm) is sequentially deposited using a sputtering scheme.

### Manufacturing example 5. Free ferromagnetic layer based on ferrimagnetic according to one embodiment of the disclosure (Co₇₀Gd₃₀)

In the magnetic device having the structure of FIG. 1, a free ferromagnetic layer is manufactured through the following process.

A ferrimagnetic-based ferromagnetic electrode multilayer film composed of Ta(2nm) / Pt(2nm) / Co(1.2nm) / Ti(2nm) / Co₇₀Gd₃₀(10nm) / Ta(3nm) is sequentially deposited using a sputtering scheme.

### Manufacturing example 6. Free ferromagnetic layer based on ferrimagnetic according to one embodiment of the disclosure (Co₆₀Gd₄₀)

In the magnetic device having the structure of FIG. 1, a free ferromagnetic layer is manufactured through the following process.

A ferrimagnetic-based ferromagnetic electrode multilayer film composed of Ta(2nm) / Pt(2nm) / Co(1.2nm) / Ti(2nm) / Co₆₀Gd₄₀(10nm) / Ta(3nm) is sequentially deposited using a sputtering scheme.

### Experimental example 1. Confirmation of magnetization compensation point of ferrimagnetic based ferromagnetic electrode.

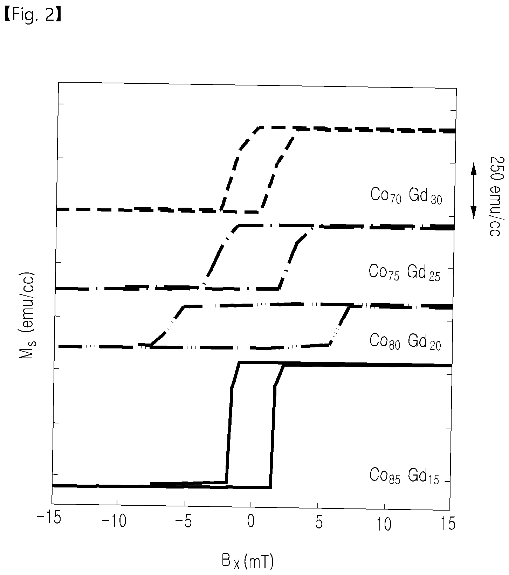

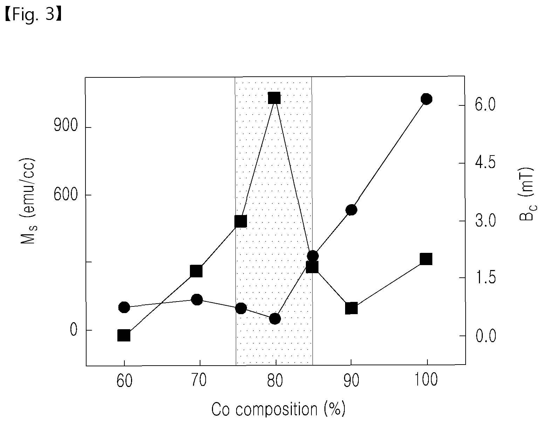

Experimental example 1 is described with reference to FIGS. 2 and 3.

FIG. 2 is a graph showing a hysteresis curve according to the composition of an in-plane magnetic anisotropy ferrimagnetic layer (CoGd) of a magnetic device according to an embodiment of the disclosure.

Referring to FIG. 2, the saturation magnetization value (Mₛ) and coercive force value (B_{c}) of the CoGd thin film according to the Co composition may be confirmed by measuring the in-plane magnetic hysteresis curve of the deposited thin film.

FIG. 3 is a graph showing a saturation magnetization value (Mₛ) and coercivity according to the composition of an in-plane magnetic anisotropy ferrimagnetic layer (CoGd) of a magnetic device according to an embodiment of the disclosure.

As described above, a ferrimagnetic material has the smallest saturation magnetization value and the largest coercivity at the magnetization compensation point because the magnetization directions of the two sublattices with different sizes are aligned antiparallel.

Referring to FIG. 3, it is possible to confirm that the magnetization compensation point of the CoGd thin film is positioned between the compositions of Co₇₅Gd₁₅ and CossGdis.

Table 1 below summarizes the values of FIG. 3.

**<Table 1>**

| Co composition (%) | saturation magnetization value (Mₛ) emu/cc |
|---|---|
| 60 | 102 |
| 70 | 135 |
| 75 | 94 |
| 80 | 47 |
| 85 | 324 |
| 90 | 530 |
| 100 | 1021 |

### Experimental example 2. Switching and energy efficiency measurement of magnetic device.

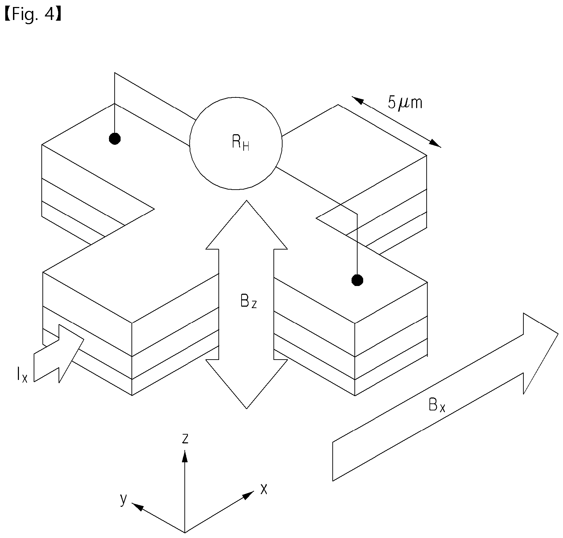

Experimental example 2 is described with reference to FIGS. 4 to 10.

FIG. 4 is a schematic view showing the structure of a magnetic device and a spin-orbit torque switching characteristic measurement according to an embodiment of the disclosure.

In order to evaluate the spin-orbit torque switching characteristics of a magnetic device according to an embodiment of the disclosure, a Hall bar element with a current line of 5 µm and a voltage line of 3 µm was manufactured as shown in FIG. 4.

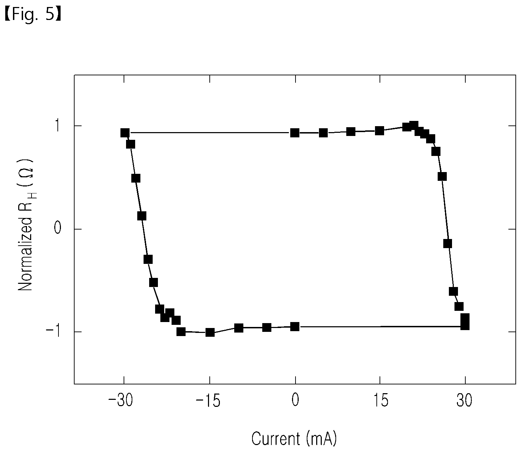

FIG. 5 is a graph showing the spin-orbit torque switching behavior of a magnetic device (Co₁₀₀Gd₀) according to a comparative example of the disclosure.

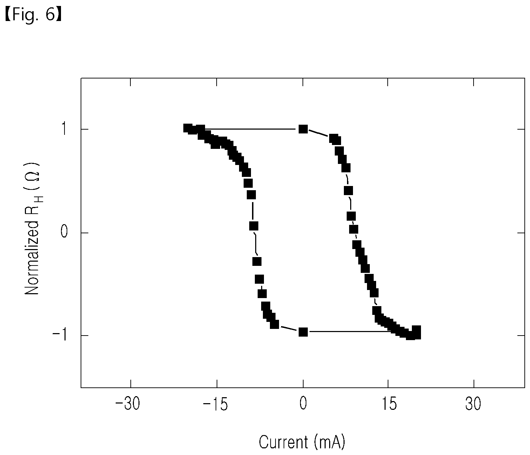

FIG. 6 is a graph showing the spin-orbit torque switching behavior of a magnetic device (Co₆₀Gd₄₀) according to an embodiment of the disclosure.

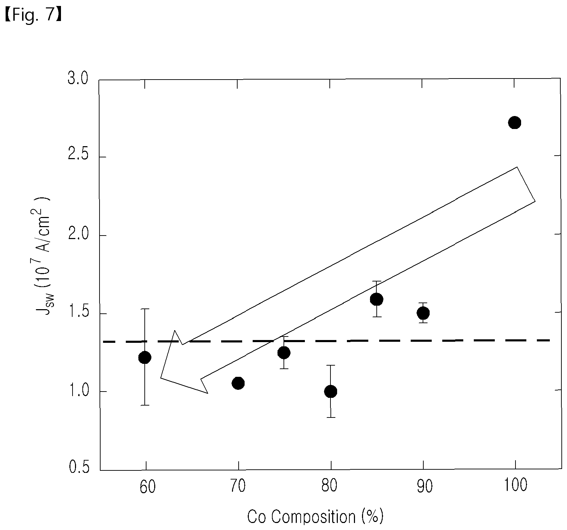

FIG. 7 is a graph showing the switching current density according to the composition of an in-plane magnetic anisotropy ferrimagnetic layer (CoGd) of a magnetic device according to an embodiment of the disclosure.

In FIGS. 5 to 7, in a state where, first, an external magnetic field was applied, an in-plane current was applied to measure the Hall resistance (R_{H}) change due to the spin-orbit torque, thereby confirming the spin-orbit torque switching.

In FIGS. 5 and 6, the switching behavior was measured while changing the current size from (+) to (-) and from (-) to (+) while applying an in-plane external magnetic field (+30 mT) to a device of each composition.

At this time, the switching current means the current when R_{H}=0, and the switching threshold current density is calculated by dividing the switching threshold current by 5 µm (current line width) × 20 nm (total device thickness).

FIGS. 5 and 6 are the results of samples with 100% and 60% Co, respectively, and

FIG. 7 shows the switching threshold current density when an external magnetic field Bₓ = +30mT in the plane direction is applied according to the Co composition, wherein referring thereto, it is possible to confirm that the switching threshold current density decreases as the Co composition decreases.

In addition, by measuring the Hall resistance change due to the spin-orbit torque by applying an in-plane current in a field-free state where no external magnetic field is applied, it is shown that field-free switching is possible.

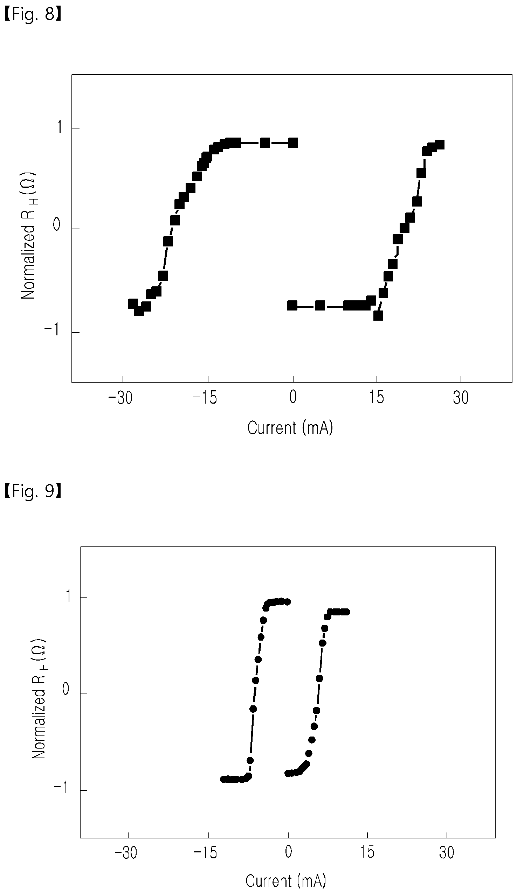

FIG. 8 is a graph showing the field-free spin-orbit torque switching behavior of a magnetic device (Co₁₀₀Gd₀) according to a comparative example of the disclosure.

FIG. 9 is a graph showing the field-free spin-orbit torque switching behavior of a magnetic device (Co₇₀Gd₃₀) according to an embodiment of the disclosure.

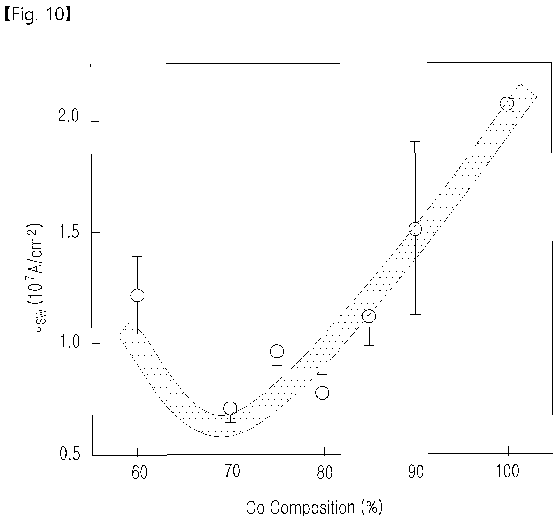

FIG. 10 is a graph showing the field-free switching current density according to the composition of an in-plane magnetic anisotropy ferrimagnetic layer (CoGd) of a magnetic device according to an embodiment of the disclosure.

In FIGS. 8 and 9, the Hall resistance (RH) is measured while increasing the threshold current by 0.5 mA units in a state where the magnetization direction is initialized to the +z (-z) direction (R_{H} = 1, -1), and switching is completed when the -z (+z) state is reached.

At this time, the switching threshold current means the current when R_{H}=0, and the switching threshold current density is calculated by dividing the switching threshold current by 5 µm (current line width) × 20 nm (total device thickness).

FIG. 10 shows the switching threshold current density of field-free switching according to the Co composition, wherein referring thereto, it is possible to confirm that the switching threshold current density is the smallest near the magnetization compensation point, and that the switching threshold current density increases as the Co composition increases or decreases (as it moves away from the magnetization compensation point).

At this time, the current density required for magnetization reversal of the magnetic device according to an embodiment of the disclosure is 6.5×10⁶ A/cm².

The figure above is a reduction effect of more than 300% compared to the field-free spin-orbit torque switching current density of 2.0×10⁷ A/cm² in the ferromagnetic (Co 100%)/non-magnetic structure, and
this technology may be applied to spin-orbit torque magnetic memory, thereby increasing the energy efficiency of the spin-orbit torque magnetic memory.

From the above results, it is possible to confirm that the magnitude of the spin current and spin-orbit torque increases in the sample with CoGd having a composition corresponding to the range near the magnetization compensation point, and as a result, the switching efficiency increases.

### Experimental example 3. Quantitative measurement of spin current according to composition of ferrimagnetic materials.

In order to quantitatively analyze the spin current generated in a ferrimagnetic material, the anomalous Hall effect of a device was measured while applying an in-plane magnetic field (Bₓ).

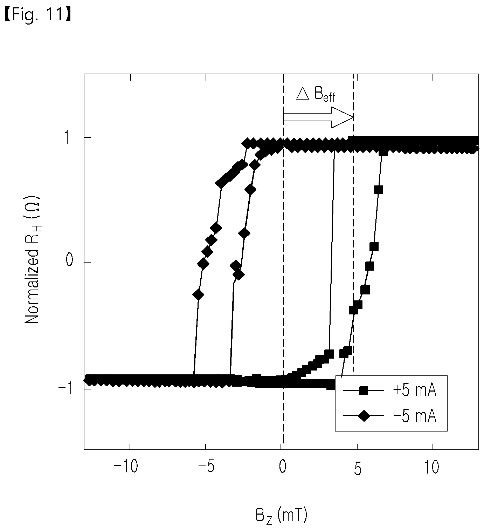

Experimental example 3 is described with reference to FIGS. 11 to 15.

FIG. 11 is a graph showing the abnormal Hall effect shift when an external magnetic field in the plane direction of a magnetic device (Co₇₀Gd₃₀) is present according to an embodiment of the disclosure.

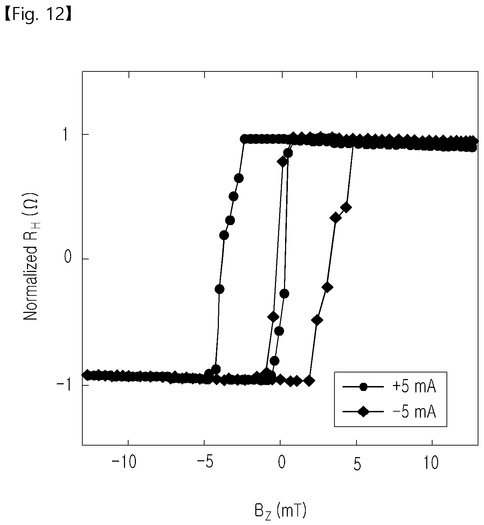

FIG. 12 is a graph showing the abnormal Hall effect shift when an external magnetic field in the plane direction of a magnetic device (Co₇₀Gd₃₀) is absent according to an embodiment of the disclosure.

FIGS. 11 and 12 are measurements taken under the conditions of Bₓ of 200 mT and 0 mT at a measurement current of ±5 mA in a sample having a quasi-magnetic material (Co₇₀Gd₃₀), and the curves of the abnormal Hall effect measured at +5 mA and the abnormal Hall effect measured at -5 mA shift in parallel in opposite directions.

From ΔB_{eff}, the degree of the parallel shift, the in-plane spin current (y-spin) and the spin current perpendicular to the plane (z-spin) may be extracted and quantified.

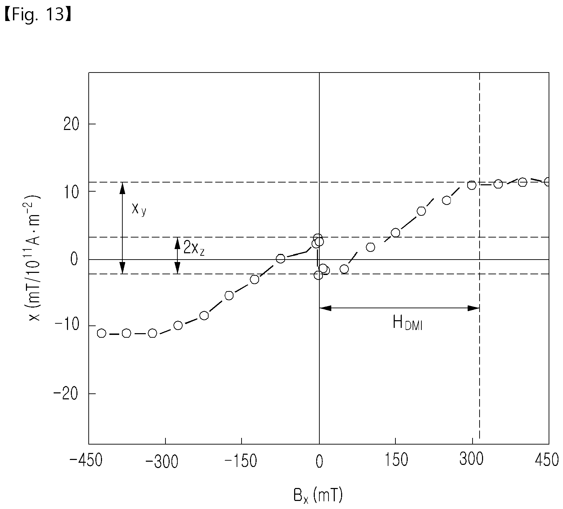

FIG. 13 is a graph showing the spin-orbit torque efficiency of a magnetic device (Co₇₀Gd₃₀) according to an embodiment of the disclosure.

More specifically, FIG. 13 shows the measured ΔB_{eff} as a function of Bₓ, and in the case of Bₓ = 0, the spin-orbit torque due to z-spin is the main cause, and the size of z-spin can be obtained from ΔB_{eff}.

In addition, as Bₓ increases, ΔB_{eff} gradually increases, and saturation is made when Bₓ = 300 mT or more, and the spin-orbit torque generated by y-spin can be quantified from the saturated ΔB_{eff}.

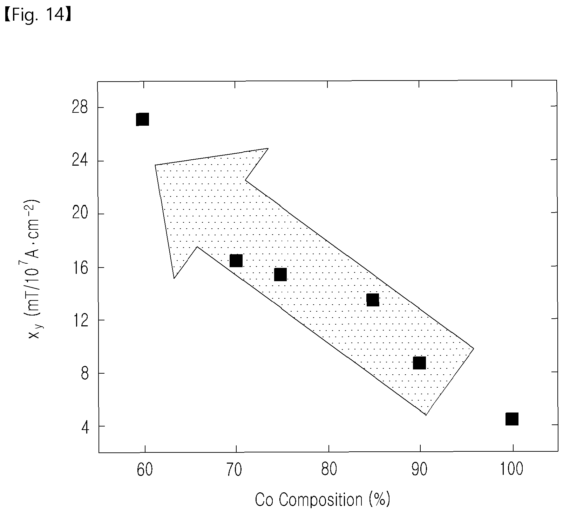

FIG. 14 is a graph showing the y-spin efficiency according to the composition of an in-plane magnetic anisotropy ferrimagnetic layer (CoGd) of a magnetic device according to an embodiment of the disclosure.

More specifically, FIG. 14 shows the spin-orbit torque efficiency (χ=ΔB_{eff}/J (measured current density) occurring in the y-spin in the ΔB_{eff}-Bₓ relationship by repeating the above experiment according to the CoGd composition, wherein it is possible to confirm that the spin-orbit torque efficiency increases as the Co composition decreases, which is consistent with the switching current density trend examined in experimental example 2 above.

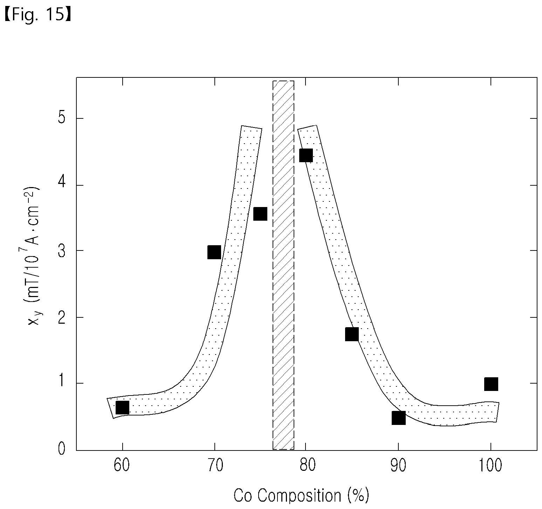

FIG. 15 is a graph showing the z-spin efficiency according to the composition of an in-plane magnetic anisotropy ferrimagnetic layer (CoGd) of a magnetic device according to an embodiment of the disclosure.

More specifically, FIG. 15 shows the z-spin efficiency according to the CoGd composition, wherein it is possible to confirm that χ is maximum when the Co composition is around 80%.

This is consistent with the field-free spin-orbit torque switching current density tendency examined in experimental example 2 above, and means that the switching energy efficiency is particularly excellent at the CoGd magnetization compensation point.

The description of the disclosure is for illustrative purposes, and those skilled in the art will understand that it can be easily modified into other specific forms without changing the technical idea or essential features of the disclosure. Therefore, the embodiments described above should be understood as being exemplary in all respects and not limiting. For example, each component described as a single type may be implemented in a distributed manner, and likewise, components described as distributed may be implemented in a combined form.

The scope of the disclosure is indicated by the following claims, and all changes or modifications derived from the meaning and scope of the claims and their equivalent concepts should be interpreted as being included in the scope of the disclosure.

## Claims

1. A magnetic device capable of field-free spin-orbit torque, comprising:
a fixed ferromagnetic layer; a free ferromagnetic layer; and an insulating layer positioned between the fixed ferromagnetic layer and the free ferromagnetic layer,
wherein the free ferromagnetic layer comprises:
an in-plane magnetic anisotropy ferrimagnetic layer; a perpendicular magnetic anisotropy free ferromagnetic layer; and a non-magnetic layer positioned between the in-plane magnetic anisotropy ferrimagnetic layer and the perpendicular magnetic anisotropy free ferromagnetic layer.

2. The magnetic device capable of field-free spin-orbit torque of claim 1, wherein the in-plane magnetic anisotropy ferrimagnetic layer has an in-plane saturation magnetization (Mₛ) value of 500 emu/cc or less.

3. The magnetic device capable of field-free spin-orbit torque of claim 1, wherein the in-plane magnetic anisotropy ferrimagnetic layer has a thickness range of 2 to 20 nm.

4. The magnetic device capable of field-free spin-orbit torque of claim 1, wherein a material constituting the in-plane magnetic anisotropy ferrimagnetic layer is represented by Chemical Formula 1:
[Chemical Formula 1] CoₓGd_{y}
In Chemical Formula 1, x and y represent the composition ratio of Co and Gd, respectively, and the sum of the x and y values is 100.

5. The magnetic device capable of field-free spin-orbit torque of claim 4, wherein the x is a number greater than or equal to 60 and less than or equal to 90.

6. The magnetic device capable of field-free spin-orbit torque of claim 1, wherein the non-magnetic layer comprises at least one selected from the group consisting of alloys comprising Pt, Ta, W, Ti, and combinations thereof.

7. The magnetic device capable of field-free spin-orbit torque of claim 1, wherein an interfacial spin current of the in-plane magnetic anisotropy ferrimagnetic layer and the non-magnetic layer applies a torque to the perpendicular magnetic anisotropy free ferromagnetic layer, thereby switching the magnetization direction of the perpendicular magnetic anisotropy free ferromagnetic layer.

8. A method for manufacturing a magnetic device capable of field-free spin-orbit torque, the method comprising:
forming a fixed ferromagnetic layer;
forming an insulating layer on the fixed ferromagnetic layer; and
forming a free ferromagnetic layer on the insulating layer,
wherein the forming of the free ferromagnetic layer comprises:
forming a perpendicular magnetic anisotropy free ferromagnetic layer;
forming a non-magnetic layer on the perpendicular magnetic anisotropy free ferromagnetic layer; and
forming an in-plane magnetic anisotropy ferrimagnetic layer on the non-magnetic layer.

9. The method of claim 8, wherein in the forming of the in-plane magnetic anisotropy ferrimagnetic layer, the in-plane magnetic anisotropy ferrimagnetic layer has an in-plane saturation magnetization (Mₛ) value of 500 emu/cc or less.

10. The method of claim 8, wherein in the forming of the in-plane magnetic anisotropy ferrimagnetic layer, the in-plane magnetic anisotropy ferrimagnetic layer has a thickness range of 2 to 20 nm.

11. The method of claim 8, wherein in the forming of the in-plane magnetic anisotropy ferrimagnetic layer, the in-plane magnetic anisotropy ferrimagnetic layer is composed of a material represented by Chemical Formula 1:
[Chemical Formula 1] CoₓGd_{y}
In Chemical Formula 1, x and y represent the composition ratio of Co and Gd, respectively, and the sum of the x and y values is 100.

12. The method of claim 11, wherein the x is a number greater than or equal to 60 and less than or equal to 90.

13. The method of claim 8, wherein the forming of the free ferromagnetic layer on the insulating layer is performed by at least one scheme selected from the group consisting of sputtering, molecular beam epitaxy (MBE), atomic layer deposition (ALD), physical vapor deposition (PVD), and chemical vapor deposition (CVD).
